# EUROPEAN PATENT APPLICATION

(11) **EP 1 057 546 A1**
(43) Date of publication of application: **06.12.2000**
(21) Application number: 00304679.4
(22) Date of filing: 01.06.2000
(51) Int. Cl.: B08B 3/12, H01L 21/00

(54) **Megasonic cleaner**

(30) Priority: 01.06.1999 US 136908 P
(71) Applicant: Applied Materials, Inc., Santa Clara, California 95054 (US)
(72) Inventor: Tang, Jianshe, Cupertino, CA 95014 (US); Brown, Brian J., Palo Alto, CA 94301 (US); Fishkin, Boris, SanCarlos, CA 94070 (US); Redeker, Fred C., Fremont, CA 94536 (US)
(74) Representative: Bayliss, Geoffrey Cyril

(57) **Abstract**

A source of degassed chemistry (29) is provided for supplying chemistry to a tank (13) in which a wafer (W) is to be submerged and megasonically cleaned, or a degasser (37) is attached to a megasonic tank's chemical circulation line. Thus, gas bubbles may be prevented from forming near the wafer, and the cleaning efficiency gradient which plagues conventional megasonic tank cleaners may be reduced. By eliminating or significantly reducing gas bubbles, the reflections which can deteriorate both the tank and the transducer may be avoided. Moreover, by removing oxygen bubbles from the chemistry, superior cleaning of copper structures may be achieved, as oxygen can undesirably etch a copper structure that is being cleaned.

## Description

The present invention relates to cleaning thin or fragile substrates with sonic energy. More specifically, the present invention relates to an improved semiconductor wafer cleaning system which employs megasonic energy within a tank of fluid.

A conventional method for cleaning particles from semiconductor wafers submerged within a tank of fluid is known as megasonic cleaning. During megasonic cleaning, a transducer oscillates between compressed and strained states at a rate near 1 MHz. The megasonic oscillation output by the transducer is coupled to the fluid contained within the tank, causing pressure oscillation therein. As the pressure in the fluid oscillates between positive and negative, cavitations or bubbles form in the liquid during negative pressure and collapse or shrink during positive pressure. This bubble oscillation gently cleans the surface of the wafer.

In practice, megasonic cleaners experience a number of limitations. For instance, transducers with higher power density assure better cleaning efficiency, but generate considerable heat during operation. Accordingly, transducer cooling systems are often used to prevent degradation of adhesive material that adheres a transducer to a material that couples the transducer's acoustic power to the cleaning fluid. However, such transducer cooling systems undesirably increase the cost and complexity of a megasonic cleaning system.

In addition to heating the transducer, increased power density output by the transducer may deteriorate transducer performance and can cause burns or otherwise deteriorate the tank itself, which is typically plastic. As well, although cleaning effectiveness increases in the lower portion of the tank, the upper portion does not experience a proportional increase, necessitating wafer rotation in order to achieve uniform cleaning across the entire wafer surface.

Accordingly, a need exists for an improved method and apparatus for sonic cleaning of semiconductor wafers.

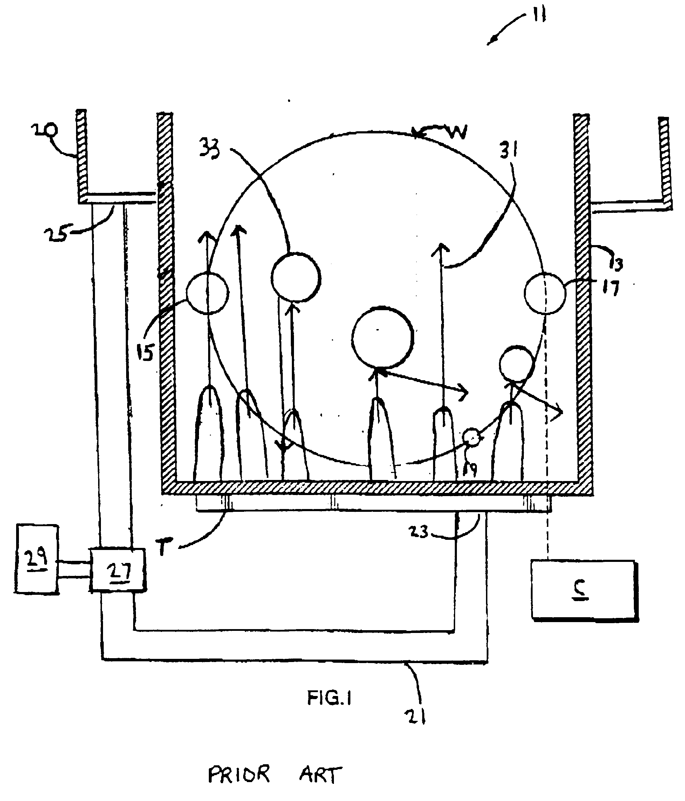

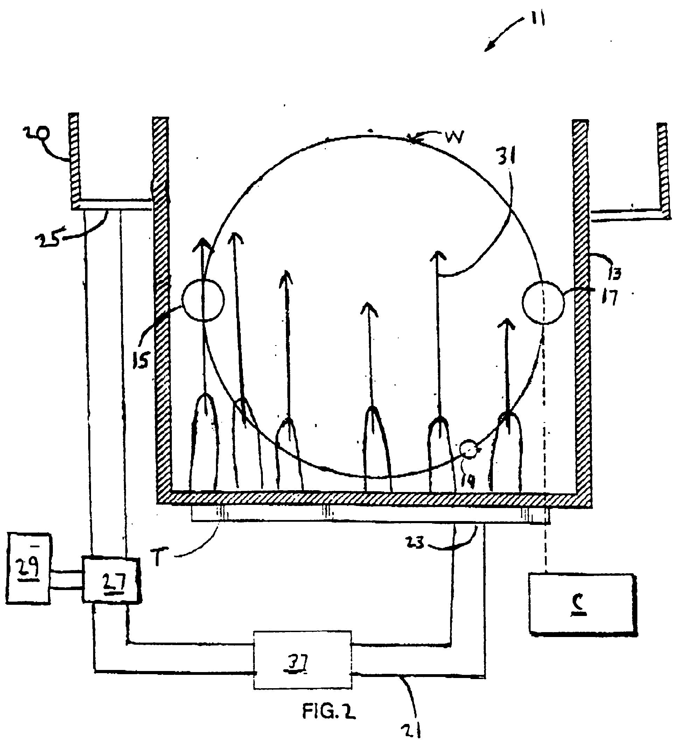

The present invention may enable cleaning efficiency increases without increasing the power density output by the transducer, and may enable power density increases without deterioration of the transducer or the plastic tank. Moreover, the present invention may provide greater cleaning uniformity across the surface of the wafer and may therefore eliminate the need for wafer rotation. Specifically, the present inventors have discovered that gas bubbles in the cleaning chemistry cause reflections that can heat and deteriorate the plastic tank, that can heat the transducer and deteriorate transducer performance, and that can contribute significantly to the uneven cleaning experienced between the upper and lower portions of the tank, as described below with reference to FIG. 1.

By providing a source of degassed chemistry for supplying chemistry to a tank in which a wafer is to be submerged and megasonically cleaned, or by attaching a degasser to a megasonic tank's chemical circulation line, the present invention may prevent bubbles that are not created by the transducer's oscillation (e.g., air or gas bubbles) from forming near the wafer, and may prevent the cleaning efficiency gradient which plagues conventional megasonic tank cleaners. By eliminating or significantly reducing such bubbles (hereinafter gas bubbles), the reflections which can deteriorate both the tank and the transducer may be avoided. Moreover, by removing oxygen bubbles from the chemistry, superior cleaning of copper structures may be achieved, as oxygen can undesirably etch a copper structure that is being cleaned.

Other features and advantages of the present invention will become more fully apparent from the following detailed description of the preferred embodiments, with reference to the accompanying drawings in which:
FIG. 1 is a front elevational view of a megasonic tank useful in describing the energy gradient experienced by conventional megasonic tanks; and
FIG. 2 is a front elevational view of an inventive cleaning system which may virtually eliminate energy gradients.

FIG. 1 is a front elevational view of a megasonic tank system 11. The megasonic tank system 11 comprises a tank 13 (e.g., a plastic tank), having a transducer mechanism (e.g., transducer T) positioned along the bottom thereof. The transducer preferably is equal in length to the diameter of a wafer W to be cleaned thereby. Above the transducer T a first wafer support 15 and a second wafer support 17 are positioned to vertically support a wafer W in line with the transducer T. A stabilizing mechanism 19 may be positioned at the wafer's baricenter so as to prevent horizontal movement of the wafer W. Typically the wafer supports 15 and 17 and the stabilizing mechanism 19 are rotatable, and each preferably comprises a groove for supporting a wafer with minimal contact. One or more of the rotatable mechanisms 15, 17 or 19 is motorized so as to rotate, and to thereby cause the wafer W to rotate therewith. An overflow weir 20 is coupled near the top of the tank 13 so as to receive overflow therefrom, and a chemical circulation line 21 having an inlet 23 coupled to the bottom of the tank 13, a drain 25 coupled to the overflow weir 20 and a pump 27 is also coupled to the tank 13. A source of cleaning chemistry 29 is coupled to the chemical circulation line 21 so that the pump 27 can pump chemistry therefrom, as shown.

In operation, the tank 13 is filled with a cleaning chemistry such as SC1 or deionized water. The wafer is positioned on the wafer supports 15, 17, and the transducer T is energized and outputs a plurality of acoustic waves 31. However, because the cleaning solution contains gas bubbles 33, a portion of the acoustic waves 31 will strike the gas bubbles 33 and reflect therefrom. The reflected waves 35 may strike the tank 13 which may cause burning that can generate particles and thereby contaminate the wafer. Alternatively, the reflected waves may travel back to the transducer T heating the transducer and deteriorating transducer performance. As generally represented in FIG. 1, the region above a gas bubble 33 receives a lower intensity of acoustic waves 31, causing the disparity in cleaning efficiency which has plagued conventional megasonic tanks. This cleaning disparity necessitates the use of more costly and less reliable systems adapted for wafer rotation. Moreover, the number and size of gas bubbles varies randomly over time, between facilities, and between chemistry/water sources, making the cleaning process unstable. Further, when cleaning copper structures, oxygen bubbles may undesirably etch the copper.

Accordingly, the present inventors have discovered that by degassing the cleaning chemistry (e.g., deionized water, SC1, a mixture thereof, etc.) the adverse effects described above can be avoided. Preferably, the source of cleaning chemistry 29 contains degassed chemistry. Alternatively, the advantages of the invention can be achieved by coupling a degasser to the chemical circulation line 21, as shown in FIG. 2.

FIG. 2 shows the schematic diagram of FIG. 1, with a degasser 37 coupled in the chemical circulation line 21. The degasser 37 may be coupled at any point along the chemical circulation line 21. FIG. 2 shows the degasser 37 coupled near the inlet 23.

In operation, the chemistry is continuously pumped from the tank 13 via the pump 27, and is degassed via the degasser 37 and returned to the tank 13 at a rate of 5-10 1/minute. Accordingly, the chemistry in the tank 13 contains very few gas bubbles. The transducer T is energized and outputs a plurality of acoustic waves 31 which travel to the wafer surface substantially unobstructed by gas bubbles in the chemical solution. As a result, more efficient cleaning is achieved without needing to increase the power density output by the transducer T, and the plastic tank may experience a longer useful life. Cleaning may be much more uniform between the upper and lower portions of the tank, and may be sufficiently uniform such that wafer rotation is not necessary. Preferably gas bubbles are eliminated or reduced such that the acoustic waves 31 travel to the wafer surface completely unobstructed by gas bubbles in the chemical solution.

The foregoing description discloses only the preferred embodiments of the invention, modifications of the above disclosed apparatus and method which fall within the scope of the invention will be readily apparent to those of ordinary skill in the art. It will be understood that the present invention can be advantageously used regardless of container material, number and orientation of wafers, configuration of wafer supports, specific chemistry employed, specific tank design, etc. The chemistry circulation loop shown herein is merely preferred, circulating, re-circulating or non-circulating systems, etc., may be employed. Likewise, while overflow weirs are preferred, the invention can be used with tanks that do not have overflow weirs. Any solution in which a wafer is submerged, and through which acoustic energy travels to clean the wafer's surface, will benefit from the inventive method. Any conventional degasser may be employed. The degasser may remove only gas bubbles which are several millimeters in diameter, or may remove all gas bubbles from the cleaning fluid.

Accordingly, while the present invention has been disclosed in connection with the preferred embodiments thereof, it should be understood that other embodiments may fall within the spirit and scope of the invention, as defined by the following claims.

## Claims

1. A method of cleaning a wafer, comprising:
flowing a degassed fluid into a tank;
at least partially submerging a wafer in the degassed fluid;
transmitting acoustic energy through the degassed fluid to the wafer; and
thereby cleaning the wafer.

2. A method as claimed in claim 1, wherein the steps of flowing a degassed fluid includes degassing the fluid as the fluid flows into the tank.

3. A method as claimed in claim 1, and comprising the step of draining a portion of the fluid from the tank and degassing the fluid prior to flowing the fluid back to the tank.

4. A method as claimed in claim 1, wherein the step of flowing a degassed fluid comprises providing a source of degassed fluid.

5. A method as claimed in any of claims 1 to 4, wherein the step of submerging a wafer includes providing a wafer having a copper layer formed thereon.

6. A wafer having a copper layer formed thereon and cleaned by the method of claim 5.

7. An apparatus for cleaning wafers, comprising:
a tank;
a wafer support contained within the tank;
a fluid supply line coupled to the tank; and
a degasser coupled to the fluid supply line.

8. An apparatus for cleaning wafers, comprising:
a tank;
a wafer support contained within the tank; and
a source of degassed fluid coupled to the tank.
